# EUROPEAN PATENT APPLICATION

(11) **EP 2 579 054 A1**
(43) Date of publication of application: **10.04.2013**
(21) Application number: 10852586.6
(22) Date of filing: 03.06.2010
(51) Int. Cl.: G01R 31/02

(54) **AUTOMATIC AND SELF-SUSTAINING ELECTRONIC SYSTEM FOR THE EARLY DETECTION OF SHORT-CIRCUIT FAULT CONDITIONS**

(71) Applicant: Blanco Barrera, Guadalupe Gildardo, C.P. 72080 Puebla (MX)
(72) Inventor: Blanco Barrera, Guadalupe Gildardo, C.P. 72080 Puebla (MX)
(74) Representative: Lorente Berges, Ana
(86) International application number: PCT/MX2010/000049
(87) International publication number: WO 2011/152695

(57) **Abstract**

Automatic and self-sustaining electronic system for the early detection of short-circuit fault conditions which consists of a solid-state switch formed by a power supply block and a control block, via which an optocoupler which is able to receive and differentiate between electrical signatures is activated, the arrangement of which makes it possible to recognize the type of fault condition (short circuit), to interrupt the current and to restore the latter automatically or manually without electric arcs, without a fall in the threshold and without heat dissipation, thus increasing the service life, reducing the response time and restoring the operation of the installation or electrical apparatus to be protected.

## Description

### DESCRIPTION OF THE INVENTION

### TECHNICAL SCOPE OF THE INVENTION

The invention is in the electronics field.

### BACKGROUND OF THE INVENTION

Power breakers o circuit breakers are automatic devices intended to protect electronic circuits from damage caused by overloads or by short-circuits. Their basic function is to detect a fault condition and discontinue the electrical flow in the circuit.

In spite that power breakers differ significantly from each other, depending on their size and capacity, they share some common features. In general, all breakers consist of a device able to detect a fault condition, and a current breaker device.

The breaker must then open or separate the contacts that prior to the occurrence of the fault condition, allowed normal current flow. Contacts of a standard breaker are usually made of copper, but they can also be made of silver and other metal alloys. When the current is interrupted, a voltaic arc is generated. The breaker should withstand heat dissipation resulting from the voltaic arc generated at the time power is discontinued. This results in a decreased service life of the breaker parts, due to abrasion or physical wearing out several of them, in particular the device contacts.

Different technologies of power breakers use vacuum, air or gas for cooling purposes. Several capacitors connected in parallel to direct current (DC) circuit contacts may also be used.

The International Standard IEC 60898-1 and the European Standard EN 60898-1 define the rated current of low voltage circuit breakers, according to the current they are intended to if operating at 30° C. There are 6, 10, 13, 16, 20, 25, 32, 40, 50, 63, 80, and up to 100 Ampere breakers.

Among low voltage circuit breakers the following can be mentioned:
● MCB (Miniature Circuit Breaker), with rated currents no higher than 100 A.

Their interruption characteristics are normally not adjustable, and they use thermal-magnetic operating mechanisms.
● MCCB (Molded Case Circuit Breaker), with rated currents of up to 2500 A. Current needed to activate the interruption is normally adjustable.

Large voltage circuit breakers handle currents measured in Kv (Kilovolts).

At present, in devices or systems used to interrupt electric current when a fault condition is detected, the operation of a so called Solenoid component is crucial.

The solenoid is a small-sized tridimensional wire coil. It is used to create magnetic fields in electronic cards. These fields may be then used to detect variations in electromagnetic waves.

However, these systems' performance or response time when electric fault (short-circuit) is detected is still very poor, resulting in material wearing, the creation of voltaic arcs, and threshold falls. All of these conditions have an impact on electrical installation safety, and carry the potential of a large number of accidents.

Unlike a fuse, which as its name indicates, is intended to fuse or melt down, this device is designed to be reset, i.e., so that electric current is allowed to flow again after a period as short as 30 ms, or preferably, by pressing a push button.

Also, unlike a standard power breaker that uses a thermal-magnetic element activated by a mechanic reaction to the increased voltage, and therefore, implies a higher weight and volume, with much higher reaction times, this invention employs a LED to send an optical signal that recognizes another component of the system, and that at the same time activates a logic electronic device to interrupt current with a command signal.

According to the description provided by the inventors, this technology will allow the development of new device generations aimed at protecting electrical AC and DC installations, able to handle all power ratings that are currently commercially available.

These advantages allow this technology to be considered as viable for the development of applications in extreme conditions, such as those used in industries such as security, chemistry, and petrochemical industries, aerospace technology, as well as able to compete under much more favorable conditions, as compared to products currently available in the market.

In addition to the foregoing, the device decreased weight and volume as compared to devices with similar functionalities, makes it more environmentally friendly, as it results in a significant reduction of materials to be use, several of which are toxic or becoming scarce.

### DESCRIPTION OF THE INVENTION

This is a solid state switch device, capable of receiving and differentiating electrical signatures by a number of electronic and optical elements, the arrangement of which makes it possible to recognize the type of fault condition (short circuit), to interrupt the current and to restore the latter automatically or manually with no electric arcs, no falls in the threshold, and no heat dissipation, thus increasing the service life, reducing the response time, and restoring the operation of the installation or electrical apparatus to be protected.

The invention provides electronic protection integrated in the power section to ensure that the condition of short circuit is overcome within a period on the order of tens of microseconds.

The object of the invention system consists of a series of electronic components integrated as follows:
In this layout design the following blocks can be identified:
   Block one, the main block or power block (which provides the energy needed to run the appliance); and

Secondary block or control block (which contains the components that are responsible for differentiating the type of fault condition and where appropriate, interrupting power.

Description of Block one. This block is comprised of power input (1)_{,} which can be connected to a single-phase, two-phase, three-phase current of 127, 220, 440 or more volts; a two-capacitor assembly (2), and three resistances (3) interconnecting to a rectifying bridge (4), the latter being interconnected to the following items: a resistance (5) connected to MOC (Optocoupler) (6), connected to TRIAC (7); and additionally, the rectifying bridge (4) is connected to a resistance (8) and signaling LED (9). In addition to these components, there is a resistance connected to the switch to eliminate voltage leakage on the power output.

Description of Secondary block. This block is comprised of power line input (I), which can be connected to a single-phase, two-phase, three-phase current of 127, 220, 440 or more volts; connected to a micro farad capacitor (2), followed by a rectifying bridge (3), the latter in turn being interconnected to: a transistor (4) interconnected to a capacitor (5), these being interconnected to a diode (6), a resistance (7); a capacitor (8); a micro relay (9); and a resistance (10) that feeds a signaling LED (II).

Both blocks are interconnected with a switch.

Description of the System Operation. The power line is directed to the sub-circuit assembly or block of capacitors and resistances where voltage is reduced from 127, 220 or 440 volts to 33 volts (with +/- 5% variation), and feeds the rectifying bridge, which in turn feeds MOC 3041 with 1.5 volts. The MOC drives or triggers the TRIAC Q6040P gate, which in turn is directed to the power output(s): in case of failure (short circuit) at the power output, the voltage feeds back secondary block capacitor via a switch, thus activating the block operation for opening in case of fault (short circuit).

Upon activation of the secondary block, the secondary block rectifying bridge feeds back the micro farad capacitor (2), followed by the rectifying bridge (3), the latter being interconnected to the a transistor (4) interconnected to a capacitor (5), these being interconnected to a diode (6), a resistance (7); a capacitor (8); and a micro relay (9) which interrupts the MOC power supply that triggers the TRIAC gate, thus removing the short circuit fault condition.

Once the fault (short circuit) condition is corrected, the system manually or automatically restores voltage to the power output.

### BEST WAY TO CARRY OUT THE INVENTION

The invention for which protection is sought can be preferably carried out as follows:
(1) 127 Volt single-phase current.

Description of Block one. This block is comprised of:
127 V power input (1), which is connected to a two-capacitor 22 K micro farad assembly (2), and three (one 100 K Ohm, and two 10 M Ohm) resistances (3), interconnected with a BA157GP rectifying bridge, the latter being interconnected to the following items: a 1 K Ohm resistance (5) connected to item MOC 3041 (6), connected to TRIAC Q6040P (7); and additionally, the rectifying bridge (4) is connected to a 100 KOhm resistance (8) and signaling LED (9). In addition to these components, there is a 270 Ohm resistance connected to the switch to eliminate voltage leakage on the power output.

Description of Secondary block. This block is comprised of 127 V power input (I), which is connected to a 77 K micro farad capacitor (2), followed by a BA157GP rectifying bridge, all of them being interconnected to the following items: a BC547 transistor (4) interconnected to a 16 Volt to 2.2 micro farad capacitor (5), interconnected to a IN4733A Zener diode (6), a I K Ohm resistance (7); a 16 Volt to 22 micro farad capacitor (8): a TQ2-12 volt micro relay (9); a 33 K Ohm resistor (10) that feeds a signaling LED (11).

Both blocks are interconnected with a 127 Volt 3 Ampere Switch.

Description of the System Operation. The power line is directed to the sub-circuit assembly or block of capacitors and resistances where voltage is reduced from 127 volts to 33 volts (with +/- 5% variation), and feeds the rectifying bridge, which in turn feeds MOC 3041 with 1.5 volts. The MOC drives or triggers the TRIAC Q6040P gate, which in turn is directed to the power output(s); in case of failure (short circuit) at the power output, the voltage feeds back secondary block capacitor via a switch, thus activating the block operation.

Upon activation of the secondary block, the secondary block rectifying bridge feeds the 77 K micro farad capacitor (2), followed by the BA157GP rectifying bridge (3), these being interconnected to the following items: a BC547 transistor (4) interconnected to a 16 V to 2.2 micro farad capacitor (5), these being interconnected to a IN4733A Zener diode (6), a 1 K Ohm resistance (7); a 16 Volt to 10 microfarad capacitor (8): and a TQ2-12 Volt micro replay (9) which interrupts the MOC power supply that triggers the TRIAC gate, thus removing the short circuit fault condition.

Once the fault (short circuit) condition is corrected, the system manually or automatically restores voltage to the power output.

(2) 220 Volt single-phase, two-phase and three-phase current.

Description of Block one. This block is comprised of: 220 V power input (I), which is connected to a two-capacitor 22 K micro farad assembly (2), and three (one 10 K Ohm, and two 10 M Ohm) resistances (3), interconnected with a BA157GP rectifying bridge (4), and a 10 K Ohm resistance (5), connected to the following items: MOC 3041 (6), connected to TRIAC Q6040P (7); and additionally, the rectifying bridge (4) is connected to a 100 KOhm resistance (8) and signaling LED (9). In addition to these components, there is a 270 Ohm resistance connected to the switch to eliminate voltage leakage on the power output.

Description of Secondary block. This block is comprised of 220 V power input (I), which is connected to a 47 K micro farad capacitor (2), followed by a BA157GP rectifying bridge (3), and a IK Ohm resistance, all of them being interconnected to the following items: a BC547 transistor (4) interconnected to a 16 Volt to 2.2 micro farad capacitor (5), interconnected to a IN4733A Zener diode (6), a 1 K Ohm resistance (7); a 16 Volt to 10 micro farad capacitor (8); a TQ2-12 volt micro relax (9); a 33 K Ohm resistor (10) that feeds a signaling LED (11).

Both blocks are interconnected with a 220 volt 3 ampere switch.

Description of the System Operation. The power tine is directed to the sub-circuit assembly or block of capacitors and resistances where voltage is reduced from 220 volts to 33 volts (with +/- 5% variation) and feeds the rectifying bridge, and 10 K Ohm resistance, which in turn feeds MOC 3041 with 1.5 volts. The MOC drives or triggers the TRIAC Q6040P gate, which in turn is directed to the power output(s); in case of failure (short circuit) at the power output, the voltage feeds back secondary block capacitor via a switch, thus activating the block operation.

Upon activation of the secondary block, the secondary block rectifying bridge feeds back the 47 K micro farad capacitor (2), followed by the rectifying bridge BA157GP (3) ans a 1 K Ohm resistance, these being interconnected to the following elements: a BC547 transistor (4) interconnected to a 16 V to 2.2 micro farad capacitor (5), these being interconnected to a IN4733A Zener diode (6), a I K Ohm resistance (7); a 16 Volt to 10 microfarad capacitor (8); and a TQ2-12 Volt micro relay (9) which interrupts the MOC power supply that triggers the TRIAC gate, thus removing the short circuit fault conditions.

Once the fault (short circuit) condition is corrected, the system manually or automatically restores voltage to the power output.

### TWO-PHASE AND THREE-PHASE OPERATION:

An electronic system comprising power block and control block is placed in each phase.

At the time failure between Phase 1 and Phase 2 occurs, Phase 1 control block discontinues power supply of Phase 2.

In turn, Phase 2 control block stops Phase 3 MOC signal, and in a similar way Phase 3 control block interrupts Phase 1 power block signal.

For interconnection between Phases 2 and 3, it is necessary to attach a switch capable of handling these two phases.

(3) 440 Volts Single-phase. Two-phase and Three-phase current

Description of Block one. This block is comprised of: 440 V power input (1), which is connected to a two-capacitor 10 K micro farad assembly (2), and three (one 10 K Ohm, and two 10 M Ohm) resistances (3), interconnected with a BA157GP rectifying bridge (4), and a 5 K Ohm resistance, connected to the following items: a 1 k Ohm resistance (5) connected to MOC 3041 (6), connected to TRIAC Q6040P (7); and additionally, the rectifying bridge (4) is connected to a 100 KOhm resistance (8) and signaling LED (9). In addition to these components, there is a 270 Ohm resistance connected to the switch to eliminate voltage leakage on the power output.

Description of Secondary block. This block is comprised of 440 V power input (1), which is connected to a 33 K micro farad capacitor (2), followed by a BA157GP rectifying bridge (3), and a 500 Ohm resistance, all of them being interconnected to the following items: a BC547 transistor (4) interconnected to a 16 Volt to 2.2 micro farad capacitor (5), interconnected to a IN4733A Zener diode (6), a 1 K Ohm resistance (7): a 16 Volt to 10 micro farad capacitor (8); a TQ2-12 volt micro relay (9); a 33 K Ohm resistor (10) that feeds a signaling LED (11).

Both blocks are interconnected with a 440 volt 3 ampere switch.

Description of the System Operation. The power line is directed to the sub-circuit assembly or block of capacitors and resistances where voltage is reduced from 440 volts to 33 volts (with +/- 5% variation) and feeds the rectifying bridge and the 5 kOhm bridge, which in turn feeds MOC 3041 with 1.5 volts. The MOC drives or triggers the TRIAC Q6040P gate, which in turn is directed to the power output(s); in case of failure (short circuit) at the power output, the voltage repowers secondary block capacitor via a switch, thus activating the block operation.

Upon activation of the secondary block, the secondary block rectifying bridge feeds back the 33 K micro farad capacitor (2), followed by the rectifying bridge BA 157GP (3), and a 500 Ohm resistance, these being interconnected to the following elements: a BC547 transistor (4) interconnected to a 16 V 2.2 micro farad capacitor (5), these being interconnected to a IN4733A Zener diode (6), a 1 K Ohm resistance (7): a 16 Volt to 10 microfarad capacitor (8): and a TQ2-12 Volt micro relay (9) which interrupts the MOC power supply that triggers the TRIAC gate, thus removing the short circuit fault condition,

Once the fault (short circuit) condition is corrected, the system manually or automatically restores voltage to the power output.

### TWO-PHASE AND THREE-PHASE OPERATION

An electronic system comprised of a power block and a control block is placed in each phase.

At the time failure between Phase 1 and Phase 2 occurs. Phase 1 control block discontinues power supply of Phase 2.

In turn, Phase 2 control block stops Phase 3 MOC signal, and in a similar way Phase 3 control block stops Phase 1 I power block signal.

For interconnection between Phases 2 and 3, it is necessary to attach a switch capable of handling these two phases.

While the descriptions of exemplary values for this invention are illustrative for 127. 220 and 440 voltages and higher, but they should not be constructed as a limitation to the exclusive use of these voltages in the invention, since the values of items included in blocks 1 and 2 will be adjusted according to the desired or applied voltage.

### DESCRIPTION OF THE DRAWINGS

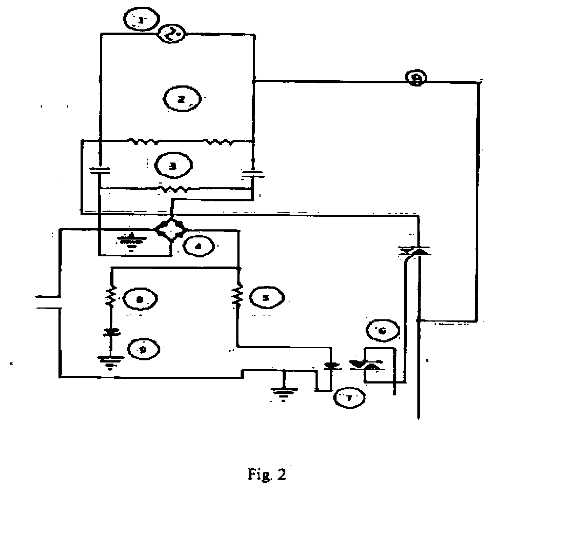

Description of the drawings:

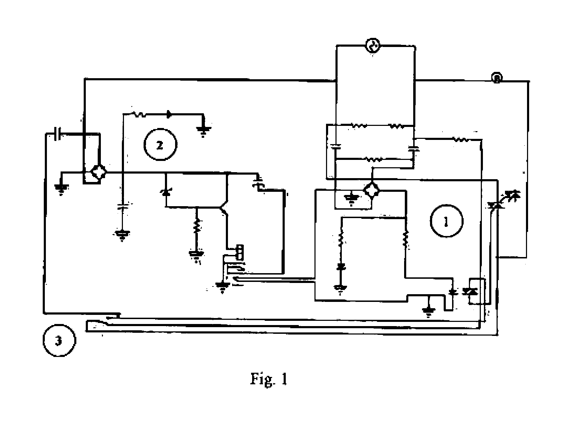

Figure 1 Automatic and self-sustaining electronic system for early detection of short circuit fault conditions
   (1) Block one:
   (2) Secondary block: and
   (3) Switch
Figure 2: Block one of the automatic electronic system and self-sustainable for fault conditions early detection in short circuit.
   (1) power input:
   (2) capacitors:
   (3) resistances:
   (4) rectifying bridge:
   (5) resistance;
   (6) MOC (Opto coupler);
   (7) TRIAC;
   (8) resistance: and
   (9) signaling led,

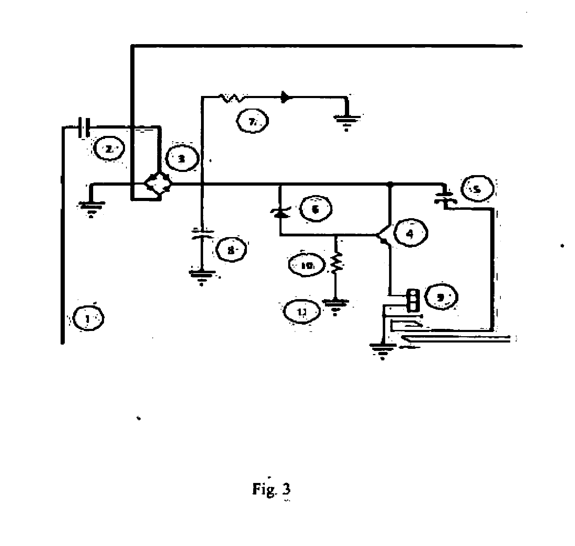

Figure 3: Secondary block of automatic and self-sustaining electronic system for screening of fault conditions in short circuit,
   (1) power supply line;
   (2) capacitor;
   (3) rectifying bridge;
   (4) a transistor;
   (5) capacitor;
   (6) Zener diode;
   (7) resistance;
   (8) capacitor;
   (9) a micro relay;
   (10) resistance; and
   (11) signaling LED.

## Claims

1. An AUTOMATIC AND SELF-SUSTAINING ELECTRONIC SYSTEM FOR EARLY DETECTION OF SHORT CIRCUIT FAULT CONDITIONS **characterized in that** the integration of two sub-circuits, one supplying sub-circuit and another control sub-circuit, that are interconnected, the circuit, and both its sub-circuits forming one solid state switch.

2. An AUTOMATIC AND SELF-SUSTAINING ELECTRONIC SYSTEM FOR EARLY DETECTION OF SHORT CIRCUIT FAULT CONDITIONS **characterized in that** the supplying block or power block of the first sub-circuit is integrated to the control or secondary sub-circuit via a switch.

3. An AUTOMATIC AND SELF-SUSTAINING ELECTRONIC SYSTEM FOR EARLY DETECTION OF SHORT CIRCUIT FAULT CONDITIONS **characterized in that** the supplying or power circuit is comprised of a power supply line that is connected to a two-capacitor assembly, and three resistances.

4. An AUTOMATIC AND SELF-SUSTAINING ELECTRONIC SYSTEM FOR EARLY DETECTION OF SHORT CIRCUIT FAULT CONDITIONS **characterized in that** the capacitor assembly, and resistances supply a rectifying bridge.

5. An AUTOMATIC AND SELF-SUSTAINING ELECTRONIC SYSTEM FOR EARLY DETECTION OF SHORT CIRCUIT FAULT CONDITIONS **characterized in that** the rectifying bridge is connected to a resistance.

6. An AUTOMATIC AND SELF-SUSTAINING ELECTRONIC SYSTEM FOR EARLY DETECTION OF SHORT CIRCUIT FAULT CONDITIONS **characterized in that** the rectifying bridge supplies a MOC optocoupler,

7. An AUTOMATIC AND SELF-SUSTAINING ELECTRONIC SYSTEM FOR EARLY DETECTION OF SHORT CIRCUIT FAULT CONDITIONS **characterized in that** the MOC optocoupler triggers the TRIAC output.

8. An AUTOMATIC AND SELF-SUSTAINING ELECTRONIC SYSTEM FOR EARLY DETECTION OF SHORT CIRCUIT FAULT CONDITIONS **characterized in that** if fault (short-circuit) occurs, output is directed through the switch towards the control block or sub-circuit.

9. An AUTOMATIC AND SELF-SUSTAINING ELECTRONIC SYSTEM FOR EARLY DETECTION OF SHORT CIRCUIT FAULT CONDITIONS **characterized in that** the control block is composed of a capacitor that requires the output directed via the switch.

10. An AUTOMATIC AND SELF-SUSTAINING ELECTRONIC SYSTEM FOR EARLY DETECTION OF SHORT CIRCUIT FAULT CONDITIONS **characterized in that** the capacitor feeds a rectifying bridge.

11. An AUTOMATIC AND SELF-SUSTAINING ELECTRONIC SYSTEM FOR EARLY DETECTION OF SHORT CIRCUIT FAULT CONDITIONS **characterized in that** the rectifying bridge is connected to a transistor assembly, a capacitor, and a Zener diode.

12. An AUTOMATIC AND SELF-SUSTAINING ELECTRONIC SYSTEM FOR EARLY DETECTION OF SHORT CIRCUIT FAULT CONDITIONS **characterized in that** the transistor assembly is connected to a capacitor with its resistance.

13. An AUTOMATIC AND SELF-SUSTAINING ELECTRONIC SYSTEM FOR EARLY DETECTION OF SHORT CIRCUIT FAULT CONDITIONS **characterized in that** the capacitor feeds a micro relay.

14. An AUTOMATIC AND SELF-SUSTAINING ELECTRONIC SYSTEM FOR EARLY DETECTION OF SHORT CIRCUIT FAULT CONDITIONS **characterized in that** the micro relay activates the MOC optocoupler, and this in turn triggers TRIAC closure.

15. An AUTOMATIC AND SELF-SUSTAINING ELECTRONIC SYSTEM FOR EARLY DETECTION OF SHORT CIRCUIT FAULT CONDITIONS **characterized in that** the TRIAC, upon output closure, interrupts output at average values of 30 micro seconds, thus presenting the creation of voltaic arcs, threshold falls, and heat dissipation.

16. An AUTOMATIC AND SELF-SUSTAINING ELECTRONIC SYSTEM FOR EARLY DETECTION OF SHORT CIRCUIT FAULT CONDITIONS **characterized in that** power supply may be either manually or automatically restored.
